(19) **Europäisches Patentamt**

**European Patent Office**

**Office européen des brevets**

(11) **EP 1 598 881 A2**

(12) **EUROPEAN PATENT APPLICATION**

(43) Date of publication:
**23.11.2005 Bulletin 2005/47**

(51) Int Cl.[7]: **H01M 2/00**

(21) Application number: **05009316.0**

(22) Date of filing: **28.04.2005**

(84) Designated Contracting States:
**AT BE BG CH CY CZ DE DK EE ES FI FR GB GR
HU IE IS IT LI LT LU MC NL PL PT RO SE SI SK TR**
Designated Extension States:
**AL BA HR LV MK YU**

(30) Priority: **29.04.2004 US 835450
01.04.2005 US 95580**

(71) Applicant: **AIR PRODUCTS AND CHEMICALS,
INC.
Allentown, PA 18195-1501 (US)**

(72) Inventors:
- **Dong, Chun Christine
  Macungie, PA 18062 (US)**
- **Ji, Bing
  Allentown, PA 18104 (US)**

(74) Representative: **Kador & Partner
Corneliusstrasse 15
80469 München (DE)**

(54) **Method for removing a substance from a substrate using electron attachment**

(57)     A method for removing a substance from at least a portion of a substrate which may be for example, a reactor or a semiconductor material, is disclosed herein. In one aspect, there is provided a method comprising: providing a reactor having a surface coated with a substance; providing a first and second electrode in proximal to the reactor wherein the first and second electrode reside within a target area; passing a gas mixture comprising a reactive gas into the target area; supplying energy to the first and/or the second electrodes to generate electrons within the target area wherein at least a portion of the electrons attach to at least a portion of the reactive gas thereby forming a negatively charged cleaning gas; contacting the substance with the negatively charged cleaning gas which reacts with the substance and forms a volatile product; and removing the volatile product from the reactor.

EP 1 598 881 A2

**Description**

BACKGROUND OF THE INVENTION

In the manufacture of semiconductor integrated circuits (IC), opto-electronic devices, microelectro-mechanical systems (MEMS), and other electronic devices, multiple steps of thin film deposition are performed in order to construct several complete circuits (chips) and devices on a substrate such as, for example, a semiconductor material. Each substrate is often deposited with a variety of thin films such as, but not limited to, conductor films, e.g., tungsten; semiconductor films, e.g., doped and undoped poly-crystalline silicon (poly-Si), doped and undoped (intrinsic) amorphous silicon (a-Si), etc.; dielectric films, e.g., silicon dioxide ($SiO_2$), undoped silicon glass (USG), boron doped silicon glass (BSG), phosphorus doped silicon glass (PSG), borophosphrosilicate glass (BPSG), silicon nitride ($Si_3N_4$), silicon oxynitride (SiON) etc.; low-k dielectric films, e.g., fluorine doped silicate glass (FSG), and carbon-doped silicon glass, such as "Black Diamond".

In modern manufacturing, thin film deposition is accomplished by placing the substrate into a processing chamber or reactor and introducing gases that undergo chemical reactions to deposit solid materials onto the surface of a substrate. An example of a typical thin film deposition process is chemical vapor deposition (CVD). These chemical reactions typically require elevated temperatures (up to 600°C) to overcome reaction activation energies. Alternatively, radio frequency (RF) energies are coupled into the vacuum chamber to ignite the precursors into a discharge state, i. e., plasma. In the latter method, higher quality films can be deposited at lower process temperatures and more efficiently using plasma energy. Such process is termed plasma enhanced chemical vapor deposition (PECVD).

The deposition process not only facilitates the growth of films onto a substrate surface but also leaves films and solid residues on the internal surfaces of the reactors. These unwanted solid residues could change the reactor surface characteristics as well as RF power coupling efficiency. Such reactor changes can also lead to deposition process performance drifts and a loss of production yield. For example, accumulated solid residues can flake off from the reactor's internal surface and deposit particles onto the wafer surface during subsequent deposition cycles. Consequently, periodic cleaning, or chamber cleaning, of the internal surfaces of the deposition reactors may be necessary to maintain production yield.

For CVD reactors, cleaning of the reactor, also referred to as chamber cleaning, may be conducted using fluorine chemistry to convert solid residues into volatile gaseous byproducts that can be pumped out of the CVD reactor by vacuum pumps. In this connection, reactive fluorine atoms (F•) are generated from fluoro-compounds. Historically, perfluorocarbons (PFCs), such as $CF_4$ and $C_2F_6$, are used as the source of reactive fluorine in plasma activated chamber cleaning. Unfortunately, using perfluorocarbon gases for chamber cleaning has significant adverse environmental impact. Perfluorocarbons, such as $CF_4$ and $C_2F_6$, strongly absorb infrared radiation and have very long atmospheric lifetimes (more than 50,000 years for $CF_4$ and 10,000 years for $C_2F_6$). As a result, these perfluorocarbon gases are the most potent greenhouse gases that cause global warming. Since perfluorocarbon molecules are very stable, they are difficult to breakdown in plasmas. In other words, the PFC destruction efficiency (DE) tends to be very low. Typical DE ranges from 5% to 20% for $CF_4$ and from 20% to 50% for $C_2F_6$. In addition to undestroyed feed PFC gases, perfluorocarbon-based chamber cleaning typically emits significant amount of $CF_4$ as explained above. Though estimates vary somewhat, it is generally agreed that up to 70% of the PFC emissions from a semiconductor fabrication facility comes from CVD chamber cleaning processes. With the exponential growth of the semiconductor industry, the PFC gas emitted from semiconductor manufacturing processes could become a significant source of global warming emissions.

Replacing perfluorocarbons with nitrogen trifluoride ($NF_3$) for CVD chamber cleaning offers dramatic improvement in reducing greenhouse gas emissions. $NF_3$ has a relatively shorter atmospheric lifetime, 750 years, compared to perfluorocarbon gases. When fully optimized, the destruction efficiency for $NF_3$ in an in situ chamber clean plasma can be above 90%. Since $NF_3$ does not contain carbon, no $CF_4$ will be emitted from $NF_3$ plasmas. Plasma can be broadly defined as a state of matter in which a significant number of the atoms and/or molecules are electrically charged or ionized. The numbers of negative and positive charges are equal, and thus the overall charge of the plasma is neutral. No global warming byproducts can be formed in $NF_3$ plasmas. Therefore, significant reductions in greenhouse gas emissions can be achieved by replacing perfluorocarbon gases with $NF_3$ in CVD chamber clean.

Currently, there are three technology platforms to utilize $NF_3$ for chamber cleaning: thermal, in situ plasma, and remote plasma. Existing $NF_3$-based CVD chamber cleaning technologies typically use either thermal or plasma activation. Both thermal and plasma activated $NF_3$ chamber cleaning technologies present challenges in $NF_3$ usage, fluorine utilization, and energy consumption. In a typical thermal chamber cleaning process using $NF_3$, $NF_3$ may need to be heated to a temperature in excess of 500°C to initiate thermal decomposition of the $NF_3$ molecule. Unfortunately, certain non-thermal CVD reactors, such as PECVD reactors, use temperature controllers to maintain the reactor at temperatures below 400°C, which is too low for effective thermal $NF_3$ cleaning. For in situ plasma cleaning, RF plasma is generated inside the reactor and high-energy electrons in the plasma dissociate $NF_3$ by electron impact. In situ plasmas, however, can become highly electronegative, such as, for example, by the formation of negative ions. When negative ions dominate over electrons as the charge carrier, the plasma becomes unstable and/or collapses within the reactor thereby leading, *inter alia,* to incomplete chamber cleaning, poor $NF_3$ utilization, and low $NF_3$ dissociation efficiency. Further, highly energetic ion bombardment that occurs during in situ cleaning may cause hardware damage. While remote plasma cleaning alleviates the drawbacks of in situ cleaning, fluorine utilization efficiency is much lower, increasing the overall cost of ownership of the process. These challenges may impede wider adoption of $NF_3$-based chamber cleaning in the industry.

In addition to chamber cleaning, etching processes are also widely used in electronic device manufacturing such as IC and MEMS fabrication. A wide variety of materials are removed or etched from a substrate . Currently, dry and wet etch processes are used. Wet etch processes use aggressive chemical solutions to etch materials. While wet etching has been used in the industry for decades, high consumption of chemicals and water resources, environmental, health, and safety concerns, and high cost of waste water processing may pose significant drawbacks. Dry processing may include thermal and plasma etch methods. Electric power consumption and reactive gas utilization are among the continuing challenges in the current dry etch processing.

BRIEF SUMMARY OF THE INVENTION

A method for removing a substance from at least a portion of a coated substrate is disclosed herein. The method described herein may be used for removing a substance from at least a portion of a substrate that is a reactor and/or any fixtures contained therein that is used, for example, in the deposition or the processing a substrate comprising a semiconductor material. In alternative embodiments, the method described herein may be used for removing a substance from a substrate (e.g., etching) such as, for example, the semiconductor material itself.

In one aspect, there is provided a method for cleaning a reactor comprising: providing the reactor wherein at least a portion of a surface of the reactor is coated with a substance; providing a first and a second electrode that is within or proximal to the reactor wherein the first and the second electrodes reside within a target area; passing a gas mixture comprising a reactive gas into the target area wherein the reactive gas has an electron affinity greater than zero; supplying energy to at least one of the first or the second electrodes to generate electrons within the target area wherein at least a portion of the electrons attach to at least a portion of the reactive gas thereby forming a negatively charged cleaning gas; contacting the substance with the negatively charged cleaning gas wherein the negatively charged cleaning gas reacts with the substance and forms at least one volatile product; and removing the at least one volatile product from the reactor.

In another aspect, there is provided a method for removing a substance from at least a portion of a surface of a reactor comprising: providing the reactor comprising at least one electrode and the surface wherein at least a portion of the surface is grounded; introducing a gas mixture comprising a reactive gas, optionally an inert diluent gas, and optionally an additive gas into the reactor; supplying voltage to the at least one electrode and/or the surface to generate electrons wherein at least a portion of the electrons attach to at least a portion of the reactive gas thereby forming a negatively charged cleaning gas; contacting the substance with the negatively charged cleaning gas wherein the negatively charged cleaning gas reacts with the substance and forms at least one volatile product; and removing the at least one volatile product from the reactor.

In a further aspect, there is provided a method removing a substance from at least a portion of a surface of a reactor comprising: introducing a reactive gas into a remote chamber that is outside of the reactor, activating the reactive gas in the remote chamber to form reactive species; providing the reactor comprising at least one electrode and the surface wherein at least a portion of the surface is grounded; introducing a gas mixture comprising a reactive gas, reactive species, and optionally an inert diluent gas into the reactor; supplying voltage to the at least one electrode and/or the surface to generate electrons wherein at least a portion of the electrons attach to at least a portion of the reactive gas thereby forming a negatively charged cleaning gas; contacting the substance with the negatively charged cleaning gas wherein the negatively charged cleaning gas reacts with the substance and forms at least one volatile product; and removing the at least one volatile product from the reactor.

In a still further aspect, there is provided a method for removing a substance from a substrate comprising a semiconductor material: providing a substrate wherein at least a portion of the surface is coated with a substance to be removed; providing a first and a second electrode that is proximal to the substrate wherein the first and the second electrode resides within a target area; passing a gas mixture comprising a reactive gas into the target area wherein the reactive gas has an electron affinity greater than zero; supplying energy to at least one of the first and the second electrodes to generate electrons within the target area wherein at least a portion of the electrons attach to at least a portion of the reactive gas thereby forming a negatively charged etching gas; contacting the substance with the negatively charged cleaning gas wherein the negatively charged etching gas reacts with the substance and forms at least one volatile product; and removing the at least one volatile product from the target area.

DETAILED DESCRIPTION OF THE INVENTION

The method described herein is useful for removing a substance from at least a portion of a substrate comprising a semiconductor material (e.g., etching) and cleaning reactors and/or fixtures contained therein for semiconductor manufacturing. Thus, suitable substrates for the etching embodiments include, e.g., semiconductor materials and the like, whereas suitable substrates for the cleaning embodiments include, e.g., surfaces of reactors for CVD and/or ALD processes. In either embodiment of the method described herein a substance can be effectively removed from at least a portion of a substrate by a negatively charged gas formed by electron attachment. The identity of substance to be removed depends upon the nature of the substrate (e.g., reactor vs. semiconductor material). In certain etching embodiments, the identity of the substance to be removed may be identical to that of the substrate itself. In these embodiments, at least a portion of the substrate may be masked to protect the portions of the surface of the substrate to remain.

The term "substrate" denotes a solid material which is the basis for the substance to be deposited upon. A substrate may include, but is not limited to, at least a portion of the surface within a reactor and/or any fixtures contained therein, or alternatively, a semiconductor material. In the later embodiments, suitable substrates that may be used include, but are not limited to, semiconductor materials such as gallium arsenide ("GaAs"), boronitride ("BN") silicon, and compositions containing silicon such as crystalline silicon, polycrystalline silicon, polysilicon, amorphous silicon, epitaxial silicon, silicon dioxide ("SiO2"), silicon carbide ("SiC"), silicon oxycarbide ("SiOC"), silicon nitride ("SiN"), silicon carbonitride ("SiCN"), organosilicate glasses ("OSG"), organofluorosilicate glasses ("OFSG"), fluorosilicate glasses ("FSG"), and other appropriate substrates or mixtures thereof including those doped with certain elements such as, but not limited to, boron phosphorous, arsenic, and gallium. Substrates may further comprise a variety of layers to which the film is applied thereto such as, for example, antireflective coatings, photoresists, organic polymers, fluorocarbon polymers, porous organic and inorganic materials, metals such as copper and aluminum, or diffusion barrier layers, e.g., TiN, Ti(C)N, TaN, Ta(C)N, Ta, W, WN, TiSiN, TaSiN, SiCN, TiSiCN, TaSiCN, or W(C)N. In certain embodiments, the method removes a non-volatile substance, such as, but not limited to, W, Ti, $SiO_2$, $TiO_2$, SiON, SiC, organosilicate glass, fluorine-doped silicate glass, porous low dielectric constant materials, poly-silicon, amorphous silicon, SiN, WN, $Al_2O_3$, $HfO_2$, $ZrO_2$, $HfSiO_4$, strontium bismuth tantalite (SBT), barium strontium titanate (BST), phosphorous zirconium titanate (PZT), processing residues such as post-etch or post-ion implantation photoresist materials and sidewall passivation films, or any of the materials described herein that are used as a semiconductor material or film deposited thereupon from at least a portion of the substrate.

The substance to be removed is converted from a non-volatile material into a volatile product that can be readily removed by the reactor vacuum pump or other means. The term "volatile product", as used herein, relates to reaction products and byproducts of the reaction between the substance to be removed and the negatively charged etching gas. Thus, the substance may be removed from at least a portion of the substrate by contacting it with the negatively charged etching gas under conditions sufficient to react with the substance and form volatile products.

The substrate having the substance to be removed is treated with a gas mixture comprising, *inter alia,* a reactive gas. The term "reactive gas" as used herein describes a gas that has an electron affinity greater than 0 and that can be used and treated by electron attachment and has a capacity for dissociative electron attachment that enables the reactive gas molecules to be dissociated thereby forming a negatively charged gas. The following demonstrates a particular embodiment wherein the gas mixture comprises the reactive gas $NF_3$ and the inert diluent gas $N_2$. In this embodiment, negatively charged fluorine ions, F⁻, are formed through dissociative attachment process of the $NF_3$ molecules as illustrated in reaction (1):

$$NF_3 \text{ (g)} + e^- \rightarrow NF_2 \text{ (g)} + F^- \text{ (g)} \tag{1}$$

The negative F⁻ ions then drift to the anode, which may be, for example, grounded internal surfaces within the reactor or the semiconductor material itself. At the anode, the negatively charged ions, such as F⁻ in equation (1), can act as active species which then react with the substance to be removed, such as $SiO_2$ in equation (2) below, to form one or more volatile products, such as $SiF_4$ and $O_2$ in equation (2):

$$4F^- \text{ (g)} + SiO_2 \text{ (s)} \rightarrow SiF_4 \text{ (g)} + O_2 \text{ (g)} + 4e^- \tag{2}$$

As a by-product of reaction (2), the free electrons may be neutralized at the grounded anode or the semiconductor material. During this process, the effect of inert gases can be very small or negligible because of their small or zero value of electron affinity (e.g. $N_2$).

The method described herein may be used, for example, in the selective removal of one or more substances from a substrate comprising a semiconductor material. Traditionally wet stripping and/or plasma etching are used in these wafer-manufacturing processes. Compared with the traditional methods, the use of a negatively charged cleaning gas may provide at least one of the following advantages: high etching rate; low operation cost; high throughput; minimized substrate damage and contamination; and low capital cost. For example, the method described herein can be used to remove a substance from a semiconductor material such as those described herein. In certain embodiments, the substance to be removed may include, but are not limited to, silicon or silicon-containing dielectric materials, metals and conductors such as W, Al, WN, Ta, TaN, organic materials such as photoresists and low-k dielectrics such as SILK™ or VELOX™. The etching process can be used to remove from selected areas of a wafer via patterned and/or anisotropic etch, or from the entire wafer for planarization, resist stripping/ashing, and wafer cleaning.

The method disclosed herein may be useful for a variety of chamber cleaning or etching processes. For example, in one embodiment, it can be used as an alternative chamber cleaning method to conventional *in situ* plasma or thermal chamber cleaning or etching methods. In this embodiment, a gas mixture comprising a reactive gas, optionally an inert diluent gas, and/or optionally an additive gas can form a negatively charged cleaning gas by electron attachment inside the reactor which may, in certain embodiments, have a semiconductor material contained therein. An electron-emitting electrode inside a chamber may be used as a cathode and the wall of the chamber may be grounded to act as an anode. In this or other embodiments, the semiconductor material with the substance to be removed may also act as anode. When an energy source such as, for example, DC voltage is applied between the two electrodes, low-energy electrons that may range, for example, from 0 to 10 eV, are emitted from the electron-emitting electrode and drift to the grounded chamber walls or semiconductor material along the electric field. During this electron drift, some reactive gas molecules can capture the electrons and form a negatively charged cleaning gas containing ions, which then act as the active species. The electron attachment processes for these gases are exothermic reactions. The negatively charged cleaning gas can then be preferentially adsorbed on the internal surface of the deposition reactor or the semiconductor material due to the electric field drifting and thus the efficiency of the reactive gas and the removal rate may be increased. Further, the electron attachment process, which uses a relatively lower energy, negatively charged cleaning gas, may minimize damage to the chamber and any fixtures contained therein or damage to the semiconductor material typically caused by high-energy positive ion bombardments.

In an alternative embodiment, the method can be used to enhance remote plasma cleaning or etching. The term "remote plasma", as used herein, relates to the generation of plasma outside of the reactor, such as for example, in a remote chamber. In remote plasma cleaning or etching, an energy source such as, but not limited to, a RF or microwave source at a relatively high power range (e.g., 100 to 14,000 W), is used to generate an intense plasma containing reactive species using a reactive gas, such as any of the reactive gases disclosed herein, in the remote chamber. In these embodiments, the gas mixture may comprise the reactive species, i.e., reactive ions or reactive atoms that were activated in a remote chamber prior to electron attachment to form the negatively charged cleaning gas. In these embodiments, the electron attachment of the reactive species and/or the reactive gas molecules may enhance the efficiency of the remotely generated plasma that is used in chamber cleaning or etching. For example, by applying the electron attachment process downstream to the remote plasma generator, neutral reactive species such as F atoms and/or $F_2$ molecules coming out of the remote plasma generator will form negatively charged ions which can act as active agents for cleaning deposition residues inside the deposition chamber which may, in certain embodiments, contain a semiconductor material. Further, negatively charged reactive species such as $F^-$ may not readily recombine to form neutral molecules such as $F_2$. Additionally, recombination byproducts such as $F_2$ can be converted into $F_2^-$ which is more reactive than its neutral counterpart ($F_2$). Improved cleaning or etching efficiency not only reduces clean time and clean gas usage but also reduces the scrubbing load of the effluent emission from chamber cleaning process. Therefore, the overall cost of ownership (COO) of the chamber cleaning or etching process can be reduced.

In a still further embodiment, the method can be used as an alternative to remote plasma cleaning or remote plasma etching. In this embodiment, the gas mixture comprising the reactive gas is passed through a target area and/or a remote negative ion generator, which contains a first and second electrode that act as a cathode and an anode. An example of a remote negative ion generator is illustrated in co-pending U. S. Pat. Appl. Serial No. 10/819,277 which is currently assigned to the assignee of the present invention and incorporated herein by reference in its entirety. In embodiments wherein the gas mixture is passed through the remote negative ion generator, the outlet of the remote negative ion generator may be in fluid communication with the reactor which may, in certain embodiments, contain a semiconductor material.

As discussed above, energy may be supplied to at least one of the electrodes, such as for example, the first electrode sufficient to cause the first electrode to generate electrons. In certain embodiments, the energy source can be an electric energy or voltage source, such as an AC or DC source. Other energy sources, such as an electromagnetic energy source, a thermal energy source, or a photo energy source may also be used alone, or in combination with any of the aforementioned energy sources. The energy source may be constant or alternatively pulsed. In certain embodiments described herein the first electrode, or cathode-acting electrode, is connected to a first voltage level and the second electrode, or anode-acting electrode, is connected to a second voltage level. In alternative embodiments, the first and second electrode may alternate between acting like a cathode an acting like an anode. The difference in the voltage levels creates a bias in electrical potential. One of the first or the second voltage levels may be zero indicating that either of the two electrodes can be grounded. In this connection, the second electrode may not be an actual electrode, but rather, the grounded walls and/or fixtures within a reactor or the semiconductor material itself.

To produce negatively charged ions by electron attachment, a relatively large quantity of electrons needs to be generated. In this connection, the electrons can be generated by a variety of ways such as, but not limited to, cathode emission, gas discharge, or combinations thereof. Among these electron generation methods, the selection of the method depends mainly on the efficiency and the energy level of the electrons generated.

As mentioned previously, for embodiments wherein the reactive gas comprises the fluorine containing gas $NF_3$, the most efficient ion formation through electron attachment is accomplished by using free electrons having an energy of ~2 eV. In these embodiments, such low energy level electrons can be generated by cathode emission and/or gas discharge. For embodiments involving electron generation through cathode emission, these embodiments may include: field emission, thermal emission, thermal-field emission, photoemission, and electron or ion beam emission.

Field emission involves applying an electric field with a negative bias on the emission electrode relative to the base electrode that is sufficiently high in intensity to overcome an energy barrier for electrons to be generated from the surface of the emission electrode. In certain embodiments, a DC voltage is applied between the two electrodes that ranges from 0.1 to 50kV, or from 2 to 30kV. In these embodiments, the distance between the electrodes may range from 0.1 to 30 cm, or from 0.5 to 5 cm.

Thermal emission, on the other hand, involves using a high temperature to energize electrons in the emission electrode and separate the electrons from the metallic bond in the material of the emission electrode. In certain preferred embodiments, the temperature of the emission electrode may range from 800 to 3500°C, or from 800 to 1500°C. The emission electrode may be brought to and/or maintained at a high temperature by a variety of methods such as, but not limited to, directly heating by passing AC or DC current through the electrode; indirect heating such as contacting the cathode surface with an electrically insulated hot surface heated by a heating element, IR radiation, or combinations thereof.

For thermal-field emission, both an electric field and a high temperature are applied. Therefore, thermal-field emission may require a lesser electric field and a lower electrode temperature for generating the same quantity of electrons as compared with pure field emission and pure thermal emission. In embodiments wherein the thermal-field emission is used for electron generation, the temperature of the first electrode that acts as the cathode may range from ambient to 3500°C, or from 150 to 1500°C. In these embodiments, the electric voltage may range from 0.01 to 20 kV or from 0.1 to 10 kV.

In embodiments wherein the cathode emission mechanism is used for generating electrons, the voltage applied between the two electrodes can be constant or pulsed. The frequency of the voltage pulse may range from 0 to 100 kHz. With applying a pulsed voltage, the arcing tendency between two electrodes can be reduced, so that the applied voltage can be increased and cathode emission can be intensified.

As mentioned previously, electrons can be generated from a first electrode that acts as a cathode when it has a negative bias relative to a second electrode that acts as an anode. In certain embodiments, the second electrode is the grounded chamber walls and/or grounded fixtures contained within the reactor. In alternative embodiments, the second electrode may be the semiconductor material to be etched. In embodiments wherein the cathode emission mechanism is used for generating electrons, the electrode material may be comprised of a conductive material with relatively low electron-emission energy or work function and a high stability under processing conditions. Examples of suitable materials include nickel, iridium, and iridium oxide. In embodiments wherein field emission is involved, the electrode is preferably made of geometries having a large surface curvature, such as thin wires or sharp tips, to intensify the electric field near the electrode surface. Further examples of geometries are provided in co-pending U. S. Pat. Appl. Serial No. 10/425,405 which is currently assigned to the assignee of the present invention and incorporated herein by reference in its entirety.

Low energy electrons may also be generated through gas phase discharge wherein the energy level of the discharged electrons may be adjusted by the pressure of the gas phase. These embodiments may include thermal discharge, photo-discharge, and various avalanche discharge, including glow discharge, arc discharge, spark discharge, and corona discharge. In these embodiments, the gas phase used for chamber cleaning or etching may contain a reactive gas and an inert diluent gas used for donating electrons wherein the electron affinity of the inert diluent gas is significantly lower than that of the reactive gas. In one particular embodiment involving gas phase discharge, a high frequency pulsed voltage may be applied between the first and second electrodes and electrons are generated from the gas mixture between two electrodes that then drift toward the anode. During the electron drift, some of these electrons may attach on the reactive gas molecules and form negatively charged ions by electron attachment. In addition, some positive ions are also created by ionization of the inert gas, which then drift toward the anode and are neutralized at the anode surface.

As mentioned previously, a gas mixture comprising a reactive gas, optionally an inert gas, and optionally an additive gas is generally used as the feed gas for chamber cleaning or etching. In either embodiment, a reactive gas with a certain electron affinity greater than 0 can be used and treated by electron attachment and has a capacity for dissociative electron attachment that enables the reactive gas molecules to be dissociated thereby forming a negatively charged gas. Examples of suitable gases include halogen-containing gases such as, but not limited to, fluorine containing gases such as $NF_3$, $F_2$, $XeF_2$, HF, chlorine containing gases such as $Cl_2$ and HCl, bromine containing gases such as HBr and $Br_2$, iodine containing gases such as HI and $I_2$, mixed halogen gases such as ClF, $ClF_3$, HF, $SF_6$, $BrF_3$, $BF_3$, and a compound having the formula $NF_nCl_{3-n}$ wherein n is a number ranging from 1 to 2, fluorocarbons such as $CF_4$, $C_2F_6$, $C_3F_8$, $C_4F_8$, oxyfluorocarbons such as $C_4F_8O$ and $COF_2$, oxyhydrofluorocarbons such as hexafluoropetanedione (Hhfac) ($CF_3C(O)CH_2C(O)CF_3$, or $C_5H_2O_2F_6$), oxychlorocarbons such as hexafluoroacetone ($CF_3C(O)CF_3$) and hexachloroacetone ($CCl_3C(O)CCl_3$), and mixed oxygen, hydrogen, and halogen compounds having the general formula $C_\alpha H_\beta X_\gamma Y_\delta O_\varepsilon$ where X and Y are one of the halogen atoms F, Cl, Br, and I, $\alpha$ is a number ranging from 1 to 6, $\beta$ is a number ranging from 0 to 13, $\gamma + \delta$ equals a number ranging from 1 to 14, and $\varepsilon$ is a number ranging from 1 to 6. Yet other examples of reactive gases include chlorocarbons and hydrochlorocarbons having the general formula $C_aH_bCl_c$, where 'a' is a number ranging from 1 to 6, 'b' is a number ranging from 0 to 13, and 'c' is a number ranging from 1 to 14. Examples of particular chlorocarbons and hydrochlorocarbons include trans-dichloroethylene $C_2H_2Cl_2$ (Trans-LC®), cis-dichloroethylene, 1,1-dichloroethylele, 1,1,1-trichloroethane ($C_2H_3Cl_3$), and tetrachloroethylene ($C_2Cl_4$). Still further examples of reactive gases include hydrogen containing gas, nitrogen containing gas, and mixtures thereof such as $NH_3$, $N_2+H_2$, hydrocarbons such as $CH_4$, $C_3H_6$, etc., amines such as $NR_xH_y$ where 'x' is a number ranging from 1 to 3, 'y' equals '3-x', and R is a functional group including, but not limited to, alkyl groups having from 1 to 12 carbon atoms. Besides the aforementioned reactive gases, any other gas that has certain electron affinity and is intrinsically reactive or can form active species by electron attachment to convert solid deposition residues into at least one volatile product is potentially applicable for the method described herein.

In certain embodiments, an inert diluent gas or a dilution gas can be added to the gas mixture. In these embodiments, the inert diluent gas has an electron affinity that is less than that of the reactive gas contained within the gas mixture. Examples of suitable inert diluent gases include, but are not limited to, $N_2$, Ar, He, Ne, Kr, Xe, and mixtures thereof. The concentration of the inert diluent gas within the gas mixture can range from 0 to 99.9 % or from 1 to 99 % by volume.

In certain embodiments, the gas mixture may comprise an additive gas. The term "additive gas" describes a gas that -unlike the reactive gas- may be incapable of dissociative attachment under processing conditions. Examples of additive gases include oxygen-containing gases such as $O_2$, $O_3$, CO, $CO_2$, NO, $N_2O$, and $NO_2$. The concentration of the additive gas within the gas mixture can range from 0 to 99.9 % or from 1 to 99 % by volume.

The selection of reactive gas, optional additive gas, and optional inert diluent gas within the gas mixture may depend upon the identity of the substance to be removed. In embodiments where the substance to be removed is selected from, for example, mono-crystalline silicon, poly-crystalline silicon, amorphous silicon, and the said materials doped with elements such as boron, phosphorous, and arsenic, and combinations thereof, the gas mixture may contain one or more reactive gases selected from certain halogen containing gases such as $F_2$, $NF_3$, $XeF_2$, $CF_4$, $C_2F_6$, $C_3F_8$, $C_4F_8$, $COF_2$, $C_{12}$, $Br_2$, HBr, HI, HF, $ClF_3$, ClF, $BrF_3$, $Cl_2$, and HCl. In these embodiments, the gas mixture may further include one or more additive gases such as $O_2$ and/or one or more inert diluent gases such as Ar and He. In embodiments wherein the substance to be removed is a silicon-containing dielectric material such as $SiO_2$, SiN, SiON, SiC, organo-silicate glass (OSG) such as BLACK DIAMOND™ and DEMS™ and fluorine-doped silicate glass (FSG), boron-doped silicate glass (BSG), undoped silicate glass (USG), DEMS, porous low-k dielectric materials such as PDEMS™ and MESOELK™, the gas mixture may contain one or more reactive gases selected from halogen containing gas, such as $F_2$, $NF_3$, $XeF_2$, $CF_4$, $C_2F_6$, $C_3F_8$, $C_4F_8$, $COF_2$, $C_{12}$, $Br_2$, HBr, HI, HF, $ClF_3$, ClF, $BrF_3$, $Cl_2$, and HCl. In these embodiments, the gas mixture may further include one or more additive gases such as $O_2$, and/or one or more inert diluent gases such as Ar and He. In embodiments where the substance to be removed includes organic polymers such as photoresists, low-k dielectric materials, fluorocarbon polymers such as TEFLON™, post-etch residues, transparent conductive polymers, and/or protective polymers, the gas mixture may contain one or more reactive gases selected from hydrogen containing and nitrogen containing gases, such as $NH_3$ or $N_2+H_2$, hydrocarbons such as $CH_4$ or $C_3H_6$, amines such as $NR_xH_y$ where x is a number ranging from 1 to 3, and y equals '3-x' and R is an alkyl group having from 1 to 12 carbon atoms. In embodiments where the substance to be removed includes organic polymers such as photoresists, low-k dielectric materials, fluorocarbon polymers, post-etch residues, post ion-implantation residues, transparent conductive polymers, and protective polymers, the gas mixture may contain one or more reactive gases selected from a halogen-containing gas, such as $F_2$, $NF_3$, $XeF_2$, $CF_4$, $C_2F_6$, $C_3F_8$, $C_4F_8$, $COF_2$, $C_{12}$, $Br_2$, HBr, HI, HF, $ClF_3$, ClF, $BrF_3$, $Cl_2$, and HCl and one or more additive gas selected from an oxygen-containing gas such as $O_2$ and $O_3$. In these embodiments, the gas mixture may further include an inert diluent gas such as $N_2$, Ar, or He. In embodiments where the substance to be removed is a metal or conductive material such as W, WN, WSi, Ta, TaN, Ti, TiSi, ITO (Indium Tin Oxide), Cu, Al, and combinations thereof, the gas mixture may contain one or more reactive gases selected from a halogen-containing gas, such as $F_2$, $NF_3$, $XeF_2$, $CF_4$, $C_2F_6$, $C_3F_8$, $C_4F_8$, $COF_2$, $C_{12}$, $Br_2$, HBr, HI, HF, $ClF_3$, CIF, $BrF_3$, $Cl_2$, and HCl. In these embodiments, the gas mixture may further include one or more additive gases such as $O_2$, and/or one or more inert diluent gases such as Ar and He. In embodiments where the substance to be removed is a metal or conductive material such as W, WN, WSi, Ta, TaN, Ti, TiSi, ITO (Indium Tin Oxide), Cu, Al, and combinations thereof, the gas mixture may contain one or more reactive gases selected from oxyfluorocarbons (e.g., hexafluoropetanedione (Hhfac) ($CF_3C(O)CH_2C(O)CF_3$ or $C_5H_2O_2F_6$)), oxy-chlorocarbons such as hexafluoroacetone ($CF_3C(O)CF_3$) and hexachloroacetone ($CCl_3C(O)CCl_3$) or mixed halogen compounds. In embodiments where the substance to be removed is metal oxide, metal nitride, metal oxynitride, metal silicate, nitrogen incorporated metal silicate, and combinations thereof, the gas mixture may contain one or more reactive gases selected from a halogen-containing gas, such as $F_2$, $NF_3$, $XeF_2$, $CF_4$, $C_2F_6$, $C_3F_8$, $C_4F_8$, $COF_2$, $C_{12}$, $Br_2$, HBr, HI, HF, $ClF_3$, CIF, $BrF_3$, $Cl_2$, and HCl. In these embodiments, the gas mixture may further include one or more additive gases such as $O_2$ and/or one or more inert diluent gases such as Ar and He. In embodiments where the substance to be removed is metal oxide, metal nitride, metal oxynitride, metal silicate, nitrogen incorporated metal silicate, and combinations thereof, the gas mixture may contain a reactive gas selected from a oxyfluorocarbon such as hexafluoropetanedione (a.k.a. Hhfac) ($CF_3C(O)CH_2C(O)CF_3$, or $C_5H_2O_2F_6$), an oxy-chlorocarbons such as hexafluoroacetone ($CF_3C(O)CF_3$) and hexachloroacetone ($CCl_3C(O)CCl_3$) or a mixed halogen compound represented having the general formula $C_\alpha H_\beta X_\gamma Y_\delta O_\varepsilon$, where X and Y are one of the halogen atoms F, Cl, Br, and I, $\alpha$ is a number ranging from 1 to 6, $\beta$ is a number ranging from 0 to 13, $\gamma + \delta$ equals a number ranging from 1 to 14, and $\varepsilon$ is a number ranging from 1 to 6. In embodiments where the substance to be removed is metal oxide, metal nitride, metal oxynitride, metal silicate, nitrogen incorporated metal silicate, and combinations thereof, the gas mixture may contain a reactive gas selected from a chlorocarbons or a hydrochlorocarbons having a general formula $C_aH_bCl_c$, where a is a number ranging from 1 to 6, b is a number ranging from 0 to 13, and c is a number ranging from 1 to 14 such as, for example, trans-dichloroethylene $C_2H_2Cl_2$ (a.k.a. Trans-LC®), cis-dichloroethylene, 1,1-dichloroethylele, 1,1,1-trichloroethane ($C_2H_3Cl_3$), and tetrachloroethylene $C_2Cl_4$.

For a given quantity of free electrons, the efficiency of the electron attachment can increase at increased gas pressure due to a reduced acceleration of the free electrons and/or an increase in collision probability between the molecules contained within the gas mixture and the free electrons. The pressure range within the reactor may range from 10 millitorr to 700 torr or from 1 torr to 700 torr. In certain embodiments, a sub-atmospheric pressure (such as 700 Torr) may be used for safety concerns to minimize outbound leak of reactive gases. When the potential hazard of outbound gas leakage is mitigated, however, the pressure can be increased to higher ranges, such as, for example, above atmospheric pressure, to further enhance the efficiency of electron attachment processes. In alternative embodiments, the pressure within the reactor is higher than that of the pressure within the target area, remote ion generator, and/or remote plasma chamber, to encourage the flow of the negatively charged cleaning gas into the reactor.

The method disclosed herein is useful for cleaning the inside of reactors and the surfaces of various fixtures contained therein such as, but not limited to, fluid inlets and outlets, showerheads, work piece platforms, etc. In these embodiments, the surface of the chamber and fixtures contained therein may be comprised of a variety of different materials including metals, such as titanium, aluminum, stainless steel, nickel, or alloys comprising same, or insulating materials, such as a ceramic, e.g., quartz or $Al_2O_3$.

In certain embodiments, the method disclosed herein may be used to enhance remote plasma chamber cleaning. In these embodiments, a remote plasma source, such as, but not limited to, a remote thermal activation source, a remote catalytically activated source, or a source which combines thermal and catalytic activation, may be used rather than an in situ plasma to generate the volatile product. In remote plasma cleaning, an intense discharge of cleaning gases is generated outside of the deposition chamber, reactive species such as reactive atoms and radicals then flow downstream into the deposition chamber to volatize the deposition residues. Either an RF or a microwave source can generate the remote plasma source. Depending upon the energy source, power ranging from 100 to 14,000 Watts may be used to activate the plasma. In certain embodiments, reactions between the negatively charged cleaning gas containing remote plasma generated reactive species and the deposition residues may be activated and/or enhanced by heating the reactor. In these embodiments, the reaction between the negatively charged cleaning gas containing the remote plasma generated reactive species and substance to be removed can be activated and/or enhanced by heating the reactor to a temperature sufficient to dissociate the one or more reactive gas contained within the reactive gas. The specific temperature required to activate the cleaning reaction with the substance to be removed depends on the reactive gas(es) adopted.

In remote thermal activation, the reactive gas first flows through a heated area such as a remote chamber outside of the vessel to be cleaned. In the remote chamber, the gas dissociates by contact with the high temperatures within a vessel outside of the reactor to be cleaned. Alternative approaches include the use of a catalytic converter to dissociate the reactive gas, or a combination of thermal heating and catalytic cracking, to facilitate activation of the one or more reactive gases within the gas mixture.

In alternative embodiments, the molecules of one or more reactive gases within the gas mixture can be dissociated by intense exposure to photons to form reactive radicals and atoms. For example, ultraviolet, deep ultraviolet and vacuum ultraviolet radiation can assist breaking strong chemical bonds in deposition residues as well as dissociating the one or more reactive gas within the gas mixture thereby increasing the removal rates of the deposition residues. Other means of activation and enhancement to the cleaning processes can also be employed. For example, one can use photon induced chemical reactions to generate reactive species and enhance the negatively charged cleaning gas that is generated by electron attachment.

In certain embodiments, the reactor can remain at substantially similar operating conditions (pressure and temperature) during the cleaning operation as during the deposition operation. For example, in embodiments wherein the reactor is a CVD reactor, the flow of deposition gas is stopped and purged from the reactor and delivery lines. If needed, the temperature of the reactor temperature may be changed to an optimum value; however in the preferred mode the reactor temperature is maintained at the deposition process conditions. A gas mixture, that may contain the reactive gas, an inert diluent gas, and/or reactive species, is flowed into the reactor. The reactive gas converts the substance, i.e., debris on the reactor surfaces into volatile compounds that are swept from the reactor. After a prescribed time, or after the concentration of the formed volatile compounds detected in the reactor effluent is below an acceptable level, the cleaning gas flow is stopped and preferably purged from the reactor and delivery lines. The flow of the deposition gas is then restarted and the CVD deposition process resumed.

**Claims**

1. A method for removing a substance from a reactor, the method comprising:

   providing the reactor wherein at least a portion of a surface of the reactor is coated with the substance;
   providing a first and a second electrode that is within or proximal to the reactor wherein the first and the second electrodes reside within a target area;
   passing a gas mixture comprising a reactive gas into the target area wherein the reactive gas has an electron affinity greater than 0;
   supplying energy to at least one of the first or the second electrodes to generate electrons within the target area wherein at least a portion of the electrons attach to at least a portion of the reactive gas thereby forming a negatively charged cleaning gas;
   contacting the substance with the negatively charged cleaning gas wherein the negatively charged cleaning gas reacts with the substance and forms at least one volatile product; and
   removing the at least one volatile product from the reactor.

2. The method of claim 1 wherein the reactive gas comprises a halogen.

3. The method of claim 2 wherein the reactive gas is at least one member selected from $NF_3$, $ClF_3$, $ClF$, $SF_6$, a perfluorocarbon, a hydrofluorocarbon, an oxyfluorocarbon, a hypofluorite, a fluoroperoxide, a fluorotrioxide, $COF_2$, $NOF$, $F_2$, a compound having the formula $NF_nCl_{3-n}$, wherein n is a number ranging from 1 to 2, an oxyhydrofluorocarbon, a chlorine containing compound, a bromine containing compound, a iodine containing compound, a mixed oxygen, hydrogen, and halogen compound having the general formula $C_\alpha H_\beta X_\gamma Y_\delta O_\varepsilon$, where X and Y are one of the halogen atoms F, Cl, Br, and I, $\alpha$ is a number ranging from 1 to 6, $\beta$ is a number ranging from 0 to 13, $\gamma + \delta$ equals a number ranging from 1 to 14, and $\varepsilon$ is a number ranging from 1 to 6, a chlorocarbon, a hydrochlorocarbon, a nitrogen and hydrogen containing compound, and mixtures thereof.

4. The method of claim 3 wherein the reactive gas is $NF_3$.

5. The method of claim 1 wherein the gas mixture comprises reactive species that were activated within a remote chamber.

6. The method of claim 1 wherein the gas mixture further comprises an inert diluent gas.

7. The method of claim 6 wherein the inert diluent gas comprises at least one selected from nitrogen, helium, argon, neon, xenon, krypton, radon, and mixtures thereof.

8. The method of claim 6 wherein the inert diluent gas has an electron affinity that is less than the electron affinity of the reactive gas.

9. The method of claim 1 wherein the energy in the supplying step is at least one source selected from the group consisting of an electric energy source, an electromagnetic energy source, a thermal energy source, an electric energy source, a photo energy source, and combinations thereof.

10. The method of claim 9 wherein the energy is an electric energy source.

11. The method of claim 1 wherein the first electrode is grounded.

12. The method of claim 1 wherein the second electrode is grounded.

13. The method of claim 1 wherein the target area resides within the reactor.

14. The method of claim 1 wherein the target area is outside of the reactor.

15. The method of claim 1 wherein the electrons are generated in the supplying step by at least one method selected from the group consisting of cathode emission, gas discharge, and combinations thereof.

16. The method of claim 15 wherein the electrons are generated by a cathode emission method selected from the group consisting of field emission, thermal emission, thermal-field emission, photoemission, and electron beam emission.

17. The method of claim 1 wherein the substance is at least one selected from a W, Ti, $SiO_2$, $TiO_2$, SiON, poly-silicon, amorphous silicon, SiN, WN, $Al_2O_3$, $HfO_2$, $ZrO_2$, $HfSiO_4$, and mixtures thereof.

18. A method of removing a substance from at least a portion of a surface of a reactor, the method comprising:

> providing the reactor comprising at least one electrode and the surface wherein at least a portion of the surface is grounded;
> introducing a gas mixture comprising a reactive gas and optionally an inert diluent gas into the reactor;
> supplying voltage to the at least one electrode and/or the surface to generate electrons wherein at least a portion of the electrons attach to at least a portion of the reactive gas thereby forming a negatively charged cleaning gas;
> contacting the substance with the negatively charged cleaning gas wherein the negatively charged cleaning gas reacts with the substance and forms at least one volatile product; and
> removing the at least one volatile product from the reactor.

19. The method of claim 18 wherein the gas mixture further comprises reactive species.

20. The method of claim 18 wherein the reactive gas is at least one member selected from $NF_3$, $ClF_3$, CIF, $SF_6$, a perfluorocarbon, a hydrofluorocarbon, an oxyfluorocarbon, a hypofluorite, a fluoroperoxide, a fluorotrioxide, $COF_2$, NOF, $F_2$, a compound having the formula $NF_nCl_{3-n}$, wherein n is a number ranging from 1 to 2, an oxyhydrofluorocarbon, a chlorine containing compound, a bromine containing compound, a iodine containing compound, a mixed oxygen, hydrogen, and halogen compound having the general formula $C_\alpha H_\beta X_\gamma Y_\delta O_\varepsilon$, where X and Y are one of the halogen atoms F, Cl, Br, and I, $\alpha$ is a number ranging from 1 to 6, $\beta$ is a number ranging from 0 to 13, $\gamma + \delta$ equals a number ranging from 1 to 14, and $\varepsilon$ is a number ranging from 1 to 6, a chlorocarbon, a hydrochlorocarbon, a nitrogen and hydrogen containing compound, and mixtures thereof.

21. The method of claim 20 wherein the reactive gas is $NF_3$.

22. The method of claim 18 wherein the substance is at least one selected from $SiO_2$, $TiO_2$, SiON, W, poly-silicon, amorphous silicon, SiN, WN, $Al_2O_3$, $HfO_2$, $ZrO_2$, $HfSiO_4$, $HfSiO_4$, and mixtures thereof.

23. The method of claim 18 wherein the voltage ranges from 0.01 to 50 kV.

24. The method of claim 23 wherein the voltage ranges from 0.1 to 30 kV.

25. The method of claim 18 wherein the voltage is pulsed.

**26.** The method of claim 18 wherein the gas mixture is at a pressure ranging from 1 Torr to 20 psia.

**27.** The method of claim 18 wherein the gas mixture comprises the inert diluent gas.

**28.** The method of claim 18 wherein the amount of inert diluent gas ranges from 1 to 99 % by volume.

**29.** A method of removing a substance from at least a portion of a surface of a reactor, the method comprising:

providing a reactive gas into a remote chamber that is outside of the reactor,

activating the reactive gas in the remote chamber to form reactive species;

providing the reactor comprising at least one electrode and the surface wherein at least a portion of the surface is grounded;

introducing a gas mixture comprising a reactive gas, reactive species, and optionally an inert diluent gas into the reactor;

supplying voltage to the at least one electrode and/or the surface to generate electrons wherein at least a portion of the electrons attach to at least a portion of the reactive gas thereby forming a negatively charged cleaning gas;

contacting the substance with the negatively charged cleaning gas wherein the negatively charged cleaning gas reacts with the substance and forms at least one volatile product; and

removing the at least one volatile product from the reactor.

**30.** The method of claim 29 wherein the activating step is conducted using power that ranges from 100 to 14,000 Watts.

**31.** A method for removing a substance from a substrate comprising a semiconductor material, the method comprising:

providing the substrate wherein at least a portion of a surface of the substrate is coated with the substance; providing a first and a second electrode that is proximal to the substrate wherein the first and the second electrodes reside within a target area; passing a gas mixture comprising a reactive gas into the target area wherein the reactive gas has an electron affinity greater than 0; supplying energy to at least one of the first or the second electrodes to generate electrons within the target area wherein at least a portion of the electrons attach to at least a portion of the reactive gas thereby forming a negatively charged etching gas; contacting the substance with the negatively charged etching gas wherein the negatively charged etching gas reacts with the substance and forms at least one volatile product; and removing the at least one volatile product from the target area.

**32.** The method of claim 31 wherein the reactive gas is at least one member selected from $NF_3$, $ClF_3$, $ClF$, $SF_6$, a perfluorocarbon, a hydrofluorocarbon, an oxyfluorocarbon, a hypofluorite, a fluoroperoxide, a fluorotrioxide, $COF_2$, $NOF$, $F_2$, a compound having the formula $NF_nCl_{3-n}$, wherein n is a number ranging from 1 to 2, an oxyhydrofluorocarbon, a chlorine containing compound, a bromine containing compound, a iodine containing compound, a mixed oxygen, hydrogen, and halogen compound having the general formula $C_\alpha H_\beta X_\gamma Y_\delta O_\varepsilon$, where X and Y are one of the halogen atoms F, Cl, Br, and I, $\alpha$ is a number ranging from 1 to 6, $\beta$ is a number ranging from 0 to 13, $\gamma + \delta$ equals a number ranging from 1 to 14, and $\varepsilon$ is a number ranging from 1 to 6, a chlorocarbon, a hydrochlorocarbon, a nitrogen and hydrogen containing compound, and mixtures thereof.

**33.** The method of claim 31 wherein the reactive gas further comprises an inert diluent gas.

**34.** The method of claim 33 wherein the inert diluent gas comprises at least one selected from nitrogen, helium, argon, neon, xenon, krypton, radon, and mixtures thereof.

**35.** The method of claim 31 wherein the reactive gas further comprises an additive gas.

**36.** The method of claim 35 wherein the additive gas comprises at least one selected from $O_2$, $O_3$, CO, $CO_2$, NO, $N_2O$, $NO_2$, and mixtures thereof.